# EUROPEAN PATENT APPLICATION

(11) **EP 4 369 328 A1**
(43) Date of publication of application: **15.05.2024**
(21) Application number: 21949403.6
(22) Date of filing: 05.07.2021
(51) Int. Cl.: G09F 9/302, G09F 9/30, G09F 9/33, H10K 50/80, H10K 59/00

(54) **MODULAR DISPLAY DEVICE AND METHOD FOR MANUFACTURING SAME**

(71) Applicant: LG Electronics Inc., Yeongdeungpo-gu Seoul 07336 (KR)
(72) Inventor: AN, Kitae, Seoul 06772 (KR); SHIM, Bongchu, Seoul 06772 (KR); CHO, Hyunwoo, Seoul 06772 (KR)
(74) Representative: Vossius & Partner Patentanwälte Rechtsanwälte mbB
(86) International application number: PCT/KR2021/008485
(87) International publication number: WO 2023/282362

(57) **Abstract**

**ABSTRACT:** The present invention can be applied to a technical field relating to display devices, and relates to a modular display device using, for example, light-emitting devices and to a method for manufacturing same. The present invention comprises: at least two display modules, each including a substrate having a first surface and a second surface, and a plurality of semiconductor light-emitting devices mounted on the first surface of the substrate; a light-absorbing layer positioned in a gap between the display modules; and an encapsulation layer positioned on the first surfaces of the display modules, wherein the light-absorbing layer may include: a first section positioned on the first surface of the substrate; a second section positioned in a gap between the display modules adjacent to each other; and a third section positioned on the second surface of the substrate.

## Description

### TECHNICAL FIELD

The present disclosure relates to a display device, and more particularly, to a modular display device using a light emitting device and method of fabricating the same.

### BACKGROUND ART

Recently, in a field of a display technology, display devices having excellent characteristics such as thinness, flexibility, and the like have been developed. On the other hand, currently commercialized major displays are represented by a LCD (liquid crystal display) and an OLED (organic light emitting diode).

On the other hand, Light Emitting Diode (LED), which is a well-known semiconductor light-emitting device that converts electric current into light, has been used as a light source for a display image of an electronic device including an information and communication device along with a GaP:N-based green LED, starting with commercialization of a red LED using a GaAsP compound semiconductor in 1962. Accordingly, a method for solving the above-described problems by implementing a display using the semiconductor light-emitting device may be proposed. Therefore, a method of solving the above-described problem may be presented by implementing a display using the semiconductor light emitting device. Such a light emitting diode has various advantages, such as a longer lifetime, a low power consumption, an excellent initial driving characteristic, a high vibration resistance, and the like, compared to a filament-based light emitting device.

On the other hand, in the case of a display using a semiconductor light-emitting device, since the semiconductor light-emitting device corresponding to each pixel should be coupled to a substrate, it may be difficult to implement a large-screen high-pixel display.

To this end, several displays may be combined into a module type to implement a large-area display device. In this case, an area between the display modules may be perceived or an unnatural feeling may be provided. Therefore, a light absorbing layer may be provided in a gap between the display modules.

For example, when the light absorbing layer located in the gap between the display modules is located only in the gap, the light absorbing layer may necessarily have a convex or concave shape in the process of forming the light absorbing layer.

In general, a light absorbing layer may be formed by injecting a resin material such as a photoresist having a black color, and the resin material may have an engraved or embossed shape during injection. Therefore, it is difficult to maintain flatness when forming the light absorbing layer.

When the light absorbing layer formed in the gap between the display modules has such a convex or concave shape, the function of the light absorbing layer may be degraded.

For example, even when the light absorbing layer is provided in the gap, the gap may be perceived by a user so that the display modules may be distinguished from each other or the continuity of a screen may be deteriorated.

Therefore, there is a need for a solution to solve such a conventional problem.

### DISCLOSURE

### TECHNICAL TASKS

One technical task of the present disclosure is to provide a modular display device and method of fabricating the same, in which when a plurality of display modules are tiled to configure a display device, a phenomenon, in which a lattice pattern is viewed due to a gap of a seam that is a gap between a plurality of the display modules and diffused reflection on a boundary surface, may be improved.

Another object of the present disclosure is to provide a modular display device capable of securing flatness of a light absorbing layer positioned between a plurality of display modules and a fabricating method thereof.

### TECHNICAL SOLUTIONS

To achieve the technical tacks, in a first aspect of the present disclosure, provided is a modular display device, including at least two display modules, each including a substrate having a first surface and a second surface and a plurality of semiconductor light emitting devices mounted on the first surface of the substrate, a light absorbing layer disposed in a gap between the display modules, and an encapsulation layer disposed on first surfaces of the display modules, wherein the light absorbing layer may include a first portion disposed on the first surface of the substrate, a second portion disposed in the gap between the display modules adjacent to each other, and a third portion disposed on the second surface of the substrate.

The modular display device may further include a support layer disposed on at least a portion of the second surface of the substrate.

The third portion may be disposed between the support layers disposed on the adjacent modules.

The support layer may be disposed such that an exposed portion exposing at least a portion of the second surface from a side of the gap is formed.

The third portion may be disposed on the exposed portion.

The first portion, the second portion, and the third portion may be continuously disposed.

The first portion and the third portion may be parallel to each other.

The first portion and the third portion may substantially form a plane.

The substrate may include a wiring electrode electrically connected to a contact electrode of the semiconductor light emitting device.

The substrate may include a glass substrate and a TFT layer formed on the glass substrate and connected to the wiring electrode.

The second portion may be configured to improve an adhesive force of the adjacent modules.

A transparent cover may be disposed on the encapsulation layer.

In a second aspect of the present disclosure, provided is a method of fabricating a modular display device, the method including preparing at least two display modules, each having semiconductor light emitting devices mounted on a first surface of a substrate, disposing the display modules adjacent to each other on a support layer to leave a gap in between such that the support layer is disposed on a second surface of the substrate, disposing an encapsulation layer on the first surface of the substrate, disposing an upper jig on the substrate positioned on the support layer, and injecting a light absorbing material into the gap after reversing the display modules together with the supporting layer, wherein the light absorbing material may be injected from a side of the second surface of the substrate to come in contact with the first surface of the substrate.

Injecting the light absorbing material may be performed until the light absorbing material is disposed on the second surface.

The support layer may be disposed in a manner of being separated from each other so that the adjacent portion is opened.

The support layer may be disposed such that an exposed portion exposing at least a portion of the second surface from a side of the gap is formed.

Injecting the light absorbing material may include injecting the light absorbing material onto the exposed portion.

The encapsulating layer may planarize the light absorbing material when the light absorbing material is injected into the exposed portion.

Disposing the encapsulation layer may include forming or attaching a release protection film on the at least two display modules, each having the semiconductor light emitting devices mounted on the first surface of the substrate.

Injecting the light absorbing material may include injecting the light absorbing material until the light absorbing material comes in contact with the second surface after coming in contact with the first surface and then filling up the gap.

### ADVANTAGEOUS EFFECTS

According to one embodiment of the present disclosure, the following effects are obtained.

First, according to one embodiment of the present disclosure, in a display device including a plurality of display modules, a light absorbing layer provided in a gap between adjacent modules may prevent diffused reflection due to the gap.

In addition, the flatness of the light absorbing layer provided in the gap between the adjacent modules may be maintained.

As described above, according to the embodiment of the present disclosure, it is possible to prevent a phenomenon in which the gap between the display modules is perceived or screen continuity is degraded due to the flatness-maintained light absorbing layer.

Furthermore, according to another embodiment of the present disclosure, there are also additional technical effects not mentioned herein. Those skilled skill in the art may understand through the application of the specification and drawings.

### DESCRIPTION OF DRAWINGS

FIG. 1 is a perspective diagram illustrating a display device according to one embodiment of the present disclosure.
FIG. 2 is an exploded perspective diagram illustrating a main configuration of a display device according to one embodiment of the present disclosure.
FIG. 3 is a cross-sectional diagram illustrating an adjacent portion of display modules of a display device according to one embodiment of the present disclosure.
FIG. 4 is a flowchart illustrating a method of fabricating a display device according to one embodiment of the present disclosure.
FIGs. 5 to 8 are cross-sectional diagrams schematically illustrating respective fabricating steps in a display device fabricating method according to one embodiment of the present disclosure.
FIGs. 9 to 12 are cross-sectional diagrams schematically illustrating respective fabricating steps in a display device fabricating method according to another embodiment of the present disclosure.

### BEST MODE

Reference will now be made in detail to embodiments of the present disclosure, examples of which are illustrated in the accompanying drawings. Wherever possible, the same reference numbers will be used throughout the drawings to refer to the same or like parts, and redundant description thereof will be omitted. As used herein, the suffixes "module" and "unit" are added or used interchangeably to facilitate preparation of this specification and are not intended to suggest distinct meanings or functions.

In describing embodiments disclosed in this specification, relevant well-known technologies may not be described in detail in order not to obscure the subject matter of the embodiments disclosed in this specification. In addition, it should be noted that the accompanying drawings are only for easy understanding of the embodiments disclosed in the present specification, and should not be construed as limiting the technical spirit disclosed in the present specification.

Furthermore, although the drawings are separately described for simplicity, embodiments implemented by combining at least two or more drawings are also within the scope of the present disclosure.

In addition, when an element such as a layer, region or module is described as being "on" another element, it is to be understood that the element may be directly on the other element or there may be an intermediate element between them.

The display device described herein is a concept including all display devices that display information with a unit pixel or a set of unit pixels. Therefore, the display device may be applied not only to finished products but also to parts. For example, a panel corresponding to a part of a digital TV also independently corresponds to the display device in the present specification. The finished products include a mobile phone, a smartphone, a laptop, a digital broadcasting terminal, a personal digital assistant (PDA), a portable multimedia player (PMP), a navigation system, a slate PC, a tablet, an Ultrabook, a digital TV, a desktop computer, and the like.

However, it will be readily apparent to those skilled in the art that the configuration according to the embodiments described herein is applicable even to a new product that will be developed later as a display device.

In addition, semiconductor light emitting devices mentioned in the present specification include an LED, a micro LED, and the like.

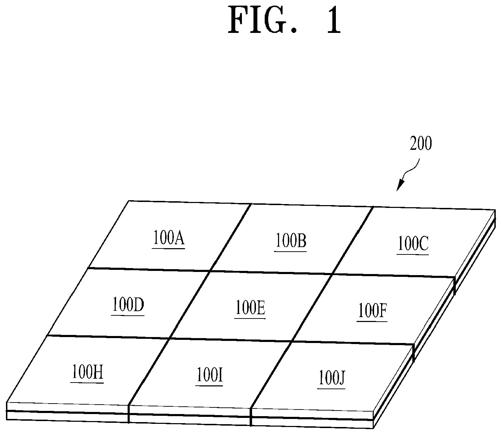

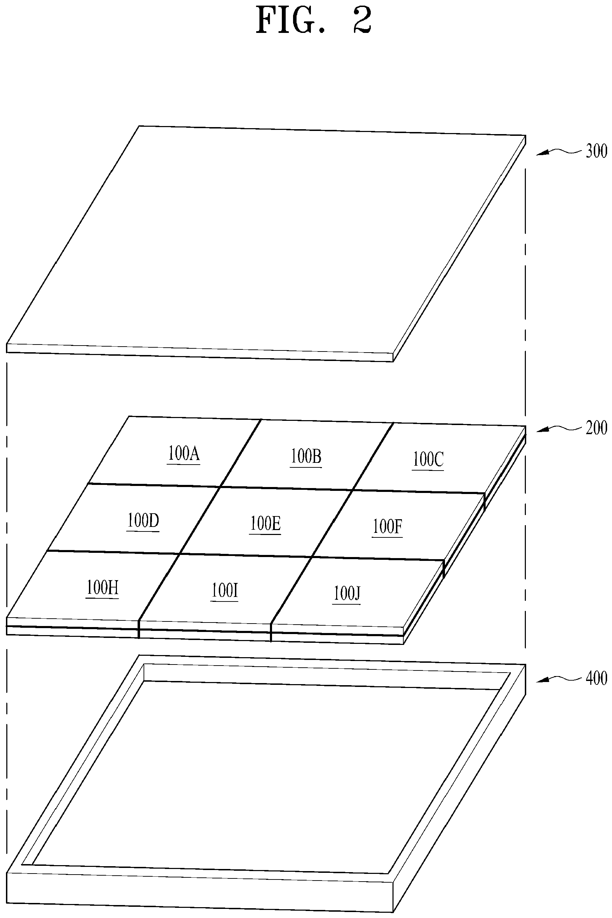

FIG. 1 is a perspective diagram illustrating a display device according to one embodiment of the present disclosure. FIG. 2 is an exploded perspective diagram illustrating a main configuration of a display device according to one embodiment of the present disclosure.

According to one embodiment of the present disclosure, a display device may include a display panel **200** displaying an image, an encapsulation layer **300** disposed on the display panel **200,** and a rear cover **400** covering a rear surface of the display panel **200.**

The display device is a device for displaying information, material, data, etc. as characters, figures, graphs, images, and the like, and a TV, a Personal Computer (PC), a mobile phone, a digital signage, and the like may be implemented as such a display device.

The display panel **200** may include at least two display modules **100A** to **100J.** As an example, the display panel 200 may be provided by tiling a plurality of the display modules **100A** to **100J.**

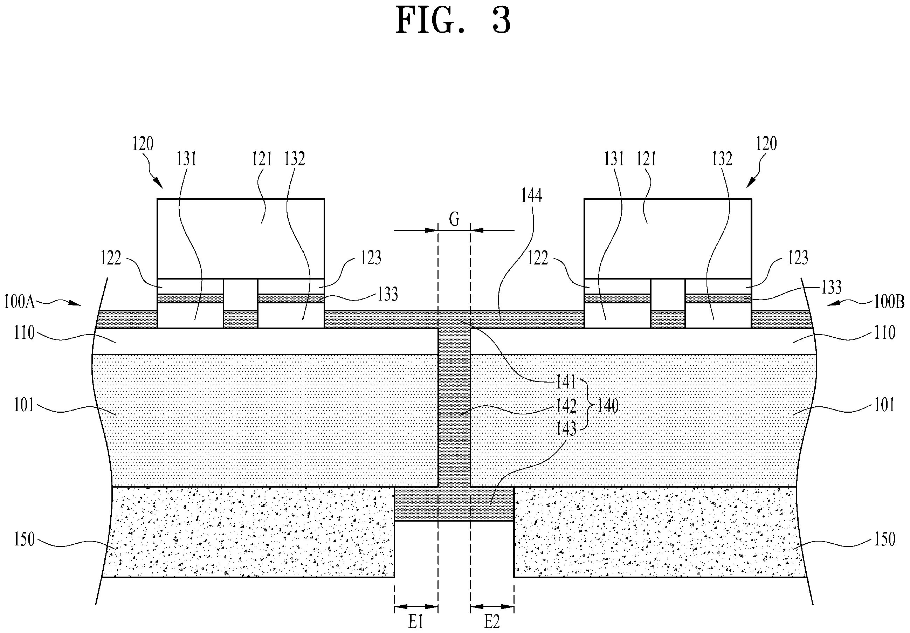

That is, a plurality of the display modules **100A** to **100J** may be vertically and horizontally arranged to be adjacent to each other. A plurality of the display modules may be arranged in a matrix form. In this embodiment, nine display modules **100A** to **100J** are arranged in a matrix form of 3 X 3, but the number and arrangement of a plurality of the display modules **100A** to **100J** are not limited thereto. For example, two modules **100A** and **100B** as illustrated in FIG. 3 may be adjacent to each other to form a single display device.

The rear cover **400** may support the display panel **200.** The display device may include a power supply device (not shown) for supplying power to a plurality of the display modules **100A** to **100J** and a controller (not shown) for controlling operations of a plurality of the display modules **100A** to **100J.**

As described above, the display device according to one embodiment of the present disclosure may implement a large screen by tiling a plurality of the display modules **100A** to **100J**

A plurality of the display modules **100A** to **100J** may have the same configuration. Therefore, the description of any one of the display modules described below may be equally applied to all other display modules.

FIG. 3 is a cross-sectional view illustrating an adjacent portion of display modules of a display device according to an embodiment of the present disclosure.

For example, FIG. 3 illustrates a state in which two display modules **100A** and **100B** are adjacent to each other.

Each of the display modules **100A** and **100B** may include a substrate 101 having a first surface and a second surface and a plurality of semiconductor light emitting devices **120** mounted on the first surface of the substrate **101.** That is, the first surface of the substrate **101** may represent a surface on which a plurality of the semiconductor light emitting devices **120** are mounted. In addition, the second surface of the substrate **101** may represent a surface opposite to the surface on which a plurality of the semiconductor light emitting devices **120** are mounted.

The substrate **101** may include wiring electrodes **131** and **132** electrically connected to contact electrodes **122** and **123** of the semiconductor light emitting device **120,** respectively. In addition, the substrate **101** may be formed of a glass substrate, and may include a TFT layer **110** formed on the glass substrate and connected to the wiring electrodes **131** and **132.**

A plurality of the semiconductor light emitting devices **120** may be formed of an inorganic semiconductor material, and each of a plurality of the semiconductor light emitting devices **120** may include a semiconductor light emitting device having a width, a length, and a height of several micrometers (µm) to several hundred micrometers (µm). Such a e micro light emitting device may have a short side size of 100 µm or less among width, length, and height thereof. The semiconductor light emitting device **120** may be picked up from a growth substrate and directly transferred on the substrate **101.**

A plurality of the semiconductor light emitting devices **120** may have light emitting structures including a semiconductor layer **121** including an n-type semiconductor layer, an active layer, a p-type semiconductor layer, and the like, and the contact electrodes **122** and **123,** and may be in the form of a flip chip in which the two contact electrodes **122** and **123** are disposed toward the same direction (e.g., a direction opposite to a light emitting direction).

The two contact electrodes **122** and **123** may be electrically connected to a pair of the wiring electrodes **131** and **132** provided on the substrate **101,** respectively. For example, a pair of the contact electrodes **122** and **123** may be electrically connected to a pair of the wiring electrodes **131** and **132** by a solder layer **133.**

For another example, a pair of the contact electrodes **122** and **123** may be electrically connected to a pair of the wiring electrodes **131** and **132** by at least one of an Anisotropic Conductive Film (ACF) and an Anisotropic Conductive Paste (ACP) in a form of a paste.

A plurality of the semiconductor light emitting devices **120** may include a red light emitting device, a green light emitting device, and a blue light emitting device. The light emitting devices **120** may be mounted on the first surface of the substrate **101** using the red light emitting device, the green light emitting device, and the blue light emitting device as one unit.

The red light emitting device, the green light emitting device, and the blue light emitting device may form one unit pixel. In this case, each of the red light emitting device, the green light emitting device, and the blue light emitting device may configure a subpixel.

The wiring electrodes **131** and **132** defining a unit subpixel area may be formed on the substrate **101** in a lattice form.

In this case, the wiring electrode **131** (hereinafter, referred to as a first wiring electrode) arranged in one direction may be a pixel electrode (or a data electrode), and the wiring electrode **132** (hereinafter, referred to as a second wiring electrode) arranged in the other direction may be a common electrode. Besides, it is a matter of course that he opposite case is also possible.

As described above, the subpixel may be defined at a point where the first wiring electrode **131** and the second wiring electrode **132** cross with each other.

As mentioned above, the first wiring electrode **131** may be connected to a Thin Film Transistor (TFT) transistor. Accordingly, the light emitting device **120** may be driven by a switching operation of the TFT.

The red light emitting device, the green light emitting device, and the blue light emitting device constituting the subpixel may be disposed at regular intervals.

A light absorbing layer **140** may be disposed over the substrate **101.** The light absorbing layer **140** may absorb external light to improve contrast. The light absorbing layer **140** may include a portion **144** formed on a side of the first surface of the substrate **101.** Specifically, the light absorbing layer **140** may be formed on the portion **144** excluding the wiring electrodes **131** and **132** on the TFT substrate **110.**

Referring to FIG. 3, when the adjacent display modules **100A** to **100B** are provided in a manner of being tiled, a gap G may be formed between the adjacent display modules **100A** and **100B.** In this gap G, light is diffused and reflected to form a sense of difference, and image quality may be deteriorated. In addition, in some cases, the gap G may be perceived by a user, so that a space between the display modules **100A** and **100B** may be distinguished or continuity of a screen may be degraded.

According to one embodiment of the present disclosure, the light absorbing layer **140** may be positioned at a portion connecting the display modules **100A** to **100B** including the gap G.

Specifically, the light absorbing layer **140** may include a first portion **141** positioned on the first surface of the substrate **101,** a second portion **142** positioned in the gap G between the display modules **100A** and **100B,** and a third portion **143** positioned on the second surface of the substrate **101.** For convenience, the first portion **141** of the light absorbing layer **140** may refer to a portion extending over the first surface from the gap G. A portion of the light absorbing layer **140** located on the first surface will be referred to as a fourth portion **144.**

For example, the first portion **141,** the second portion **142,** and the third portion **143** of the light absorbing layer **140** may be formed in a manner of being continuously connected to each other. In addition, the first portion **141** may be formed in a manner of being connected to the fourth portion **144.**

Referring to FIG. 3, a support layer **150** disposed on at least a portion of the second surface may be disposed on the second surface of the substrate **101.** In this case, the third portion **143** of the light absorbing layer **140** may be positioned between the two support layers **150** positioned in the adjacent modules **100A** and **100B,** respectively.

For example, the support layer **150** may be positioned such that exposed portions E1 and E2 exposing at least a portion of the second surface are formed near the gap G. That is, the first exposed portion E1 may be formed in the first module **100A,** and the second exposed portion E2 may be formed in the second module **100B.** The third portion **143** of the light absorbing layer **140** may be disposed on the exposed portions E1 and E2.

As described above, the first portion **141,** the second portion **142,** and the third portion **143** of the light absorbing layer **140** may be continuously disposed, and the first portion **141** and the third portion **143** may be parallel to each other. More specifically, the portion where the first portion **141** and the fourth portion **144** are connected and the third portion **143** may be parallel to each other.

In this case, the portion to which the first portion **141** and the fourth portion **144** are connected may form a substantially flat plane.

When the second portion **142** of the light absorbing layer **140** positioned in the gap G between the display modules **100A** and **100B** is positioned only within the gap G, the second portion **142** of the light absorbing layer **140** may become essentially convex or concave in the process of forming the second portion **142.**

The light absorbing layer **140** may be formed by injecting a resin material such as a photoresist having a black color, and the resin material may have an engraved or embossed shape during injection. Therefore, it is difficult to maintain flatness when the light absorbing layer **140** is formed.

When the light absorbing layer **140** formed in the gap G has such a convex or concave shape, the function of the light absorbing layer **140** may be degraded.

For example, even when the light absorbing layer **140** is provided in the gap G, the gap G is visible by the user, so that a space between the display modules **100A** and **100B** may be distinguished or continuity of a screen may be deteriorated.

Yet, as in the embodiment of the present disclosure, when the first portion **141,** the second portion **142,** and the third portion **143,** which are continuously positioned, are formed, the flatness of the light absorbing layer **140** formed in the gap G may be maintained.

Namely, it is able to secure the flatness of the first portion **141** and the third portion **143,** i.e., the portion of the light absorbing layer **140** formed in the gap G to be exposed to the outside of the gap G.

Therefore, according to the embodiment of the present disclosure, the light absorbing layer **140,** of which the flatness is maintained, may prevent the space between the display modules **100A** to **100B** from being perceived or prevent the continuity of the screen from being degraded.

Meanwhile, in some cases, the support layer **150** may be maintained as it is, but may also be removed.

In addition, as described above, the encapsulation layer **300** may be formed on a mounting surface on which a plurality of the semiconductor light emitting devices **120** are mounted, that is, on the first surface of the substrate **101.**

The light absorbing layer **140** may contain a black inorganic material, a black organic material, a black pigment, or a black metal, which may absorb light to maximize a light absorption effect.

The light absorbing layer **140** may be formed by injecting a light absorbing material between the display modules **100A** and **100B.** For example, a light absorbing resin (e.g., a black resin) material may be injected between the display modules **100A** and **100B** and then cured. The light absorption resin material may include a material such as a Black Matrix (BM).

Specifically, the light absorbing layer **140** may be formed by injecting a light absorption resin material from a side of the second surface of the substrate **101** on which the support layer **150** is located. In doing so, when the light absorption resin material is injected, the flatness may be adjusted by the encapsulation layer **300** positioned on the first surface of the substrate **101.**

That is, when the flat encapsulation layer **300** is disposed on the first surface of the substrate **101,** when the light absorption resin material is injected from the side of the second surface of the substrate **101,** the encapsulation layer **300** may maintain the flatness of the light absorbing layer **140.**

In this case, when the light absorption resin material is injected into the gap G between the display modules **100A** and **100B,** it may come in contact with the encapsulation layer 300 such that a corresponding portion may form the first portion **141** . As described above, while the flatness of the first portion **141** is maintained, the light absorption resin material may continuously fills the gap G such that a corresponding portion may form the second portion **142.** The second portion **142** of the light absorbing layer **140** positioned in the gap G may improve adhesion between the display modules **100A** and **100B.**

Thereafter, after filling the gap G, the light absorption resin material may be continuously positioned on the second surface of the substrate **101,** and a corresponding portion may form the third portion **143.**

As described above, when the support layer **150** is positioned to form the exposed portions E1 and E2 on the second surface of the substrate **101,** the third portion **143** may be located on the exposed portions E1 and E2. The third portion **143** of the light absorbing layer **140** may be flat on the exposed portions E1 and E2.

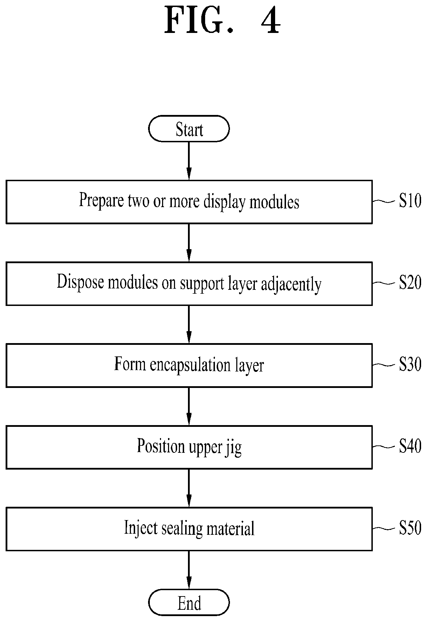

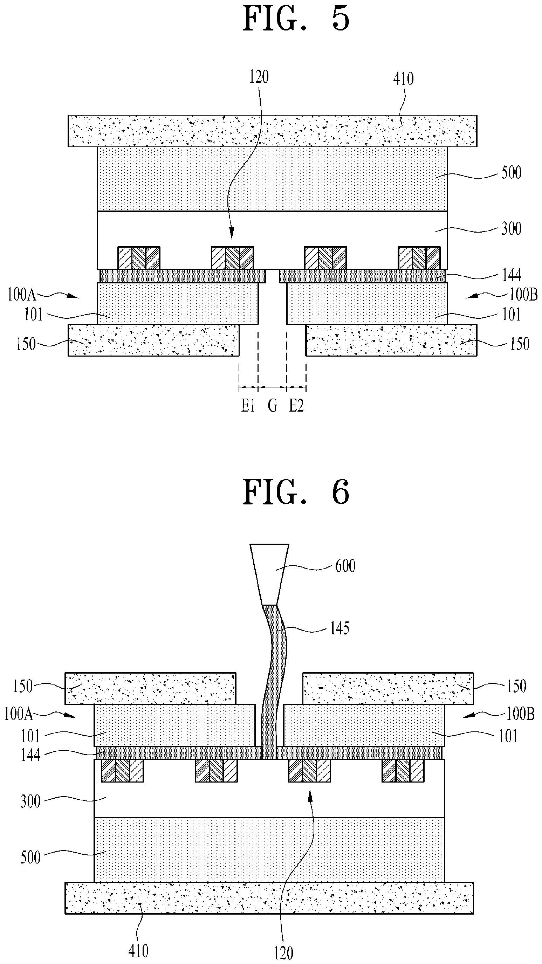

FIG. 4 is a flowchart illustrating a method of fabricating a display device according to one embodiment of the present disclosure. FIGs. 5 to 8 are cross-sectional schematic views illustrating respective fabricating steps of a method of fabricating a display device according to an embodiment of the present disclosure.

Hereinafter, a method of fabricating a display device according to one embodiment of the present disclosure will be described with reference to FIGs. 4 to 8. Each step in FIGs. 5 to 8 will be described with reference to FIG. 4.

First, referring to FIG. 4 and FIG. 5, at least two display modules **100A** to **100B** may be prepared (S10). As described above, each of the display modules **100A** and **100B** may be in a state that semiconductor light emitting devices **120** forming a plurality of pixels are mounted on a substrate **101.** In addition, a fourth portion **144** of a light absorbing layer **140** may be formed on a first surface of the substrate **101.** The light absorbing layer **140** may include a black matrix.

At least two display modules **100A** and **100B** may be disposed adjacent to each other in a manner of forming a predetermined gap G on a support layer **150** (S20). Here, as described above, the support layer **150** may be positioned such that an exposed portion E1/E2 exposing at least a portion of a second surface (i.e., a surface opposite to the surface on which the light emitting device **120** is mounted) of the substrate **101** from a side of the gap G is formed. That is, a first exposed portion E1 may be formed on the first module **100A,** and a second exposed portion E2 may be formed on the second module **100B.**

Thereafter, an encapsulation layer **300** may be formed on the first surface of the substrate **101** (S30). The encapsulation layer **300** may planarize the first surface of the substrate **101** on which the semiconductor light emitting device **120** is formed. In addition, the encapsulation layer **300** may planarize a light absorbing material when a light absorbing material is injected in a subsequent step.

The encapsulation layer **300** may include a high transmission layer such as an optically adhesive film (Optically Clear Adhesive (OCA)), an optically adhesive resin (Optically Clear Resin (OCR)), etc. The optically adhesive film may be formed in a manner of being attached onto the first surface of the substrate **101** on which the semiconductor light emitting device **120** is formed. Meanwhile, the optically adhesive resin may be directly formed on the first surface of the substrate **101** on which the semiconductor light emitting device **120** is formed. In this case, the high transmission layer may be formed or attached in a manner of filling up the gap G or failing to infiltrate into the gap G.

A transparent cover **500** may be disposed on the encapsulation layer **300.** The transparent cover **500** may cover the entire display device including a plurality of modules.

Thereafter, an upper jig **410** may be positioned on the transparent cover **500.** The upper jig **410** may be temporarily attached onto the transparent cover **500.**

As described above, when the steps S**10** to S**40** are performed, the state shown in FIG. 5 may be formed.

Next, as shown in FIG. 6, the structure of the state, in which the support layer **150** is installed and the encapsulation layer **300** and the transparent cover **500** are located on the display modules **100A** and **100B,** may be reversed using the upper jig **410.**

That is, referring to FIG. 6, the upper jig **410** may be positioned on a top side, while the support layer **150** may be positioned on a bottom side.

In this state, a sealing material **145** may be injected into the gap G (S50). As the sealing material **145,** a black resin material may be injected into the gaps G. Such a black resin may include a light absorbing material that forms a black matrix. That is, the black resin may be the same material as that of the fourth portion **144** of the light absorbing layer **140.**

As described above, when the black resin is injected into the gap G formed between the adjacent display modules **100A** and **100B,** the black resin first fills a space between the fourth portions **144** of the light absorbing layers **140** positioned on the first surfaces of the substrates **101.**

In doing so, since the encapsulation layer **300** is located at a space portion between the fourth portions **144** of the light absorbing layer **140,** the black resin may fill the space between the fourth portions **144** of the light absorbing layer **140** to make a flat surface. That is, the flatness of the injected black resin may be maintained by the encapsulation layer **300.** As described above, the encapsulation layer **300** may planarize the light absorbing material when the light absorbing material is injected.

The black resin injected into the space between the fourth portions **144** of the light absorbing layer **140** may form a first portion **141** of the light absorbing layer **140** described above.

Thereafter, the black resin may continue to fill the gap G after filling up the space between the fourth portions **144** of the light absorbing layer **140** . As described above, the black resin filling up the gap G may form a second portion **142** of the light absorbing layer **140.**

Subsequently, the black resin may be formed on the second surface of the substrate **101** after filling up the gap G. In this case, the black resin formed on the second surface of the substrate **101** may form a third portion **143** of the light absorbing layer **140.** In this case, the third portion **143** of the light absorbing layer **140** may be located in a space between the support layers **150** described above, that is, on the exposed portion E1/E2.

As described above, the step S50 of injecting the light absorbing material (e.g., sealing material) may inject the light absorbing material until the light absorbing material is positioned on the second surface of the substrate **10.**

In addition, the light absorbing material injecting step S50 may include a step of injecting the light absorbing material onto the exposed portions E1 and E2.

The flatness of the third portion **143** may be maintained on the second surface of the substrate **101.**

The black resin may then be cured to form the light absorbing layer **140.**

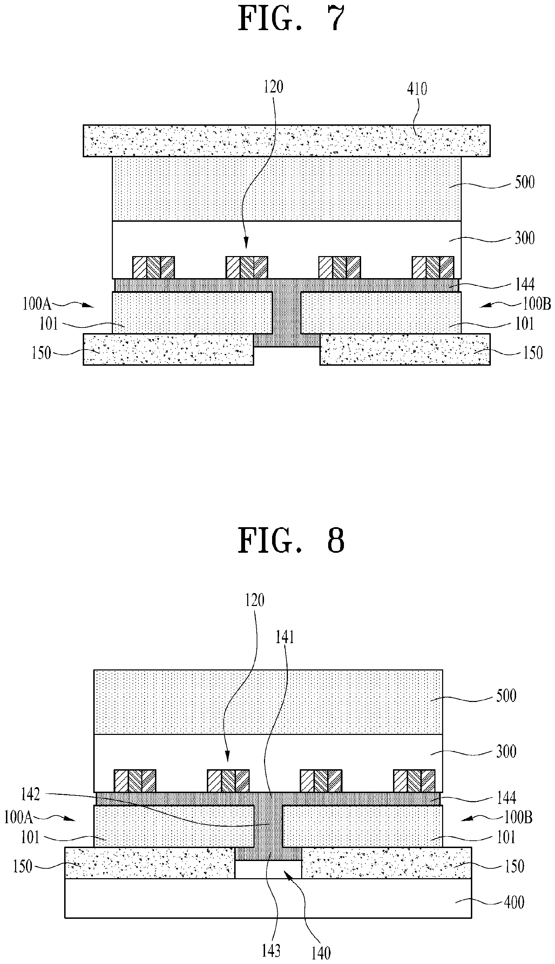

When the display modules **100A** to **100B** are reversed again to its original position using the upper jig **410,** the state shown in FIG. 7 may be obtained.

Thereafter, when the display modules **100A** and **100B** are positioned on a rear cover **400** and the upper jig **410** is then removed, the state shown in FIG. 8 may be obtained.

In some cases, the support layer **150** may be removed.

As described above, the first portion **141,** the second portion **142,** and the third portion **143** of the light absorbing layer **140** may be continuously disposed, and the first portion **141** and the third portion **143** may be parallel to each other. More specifically, a portion where the first portion **141** and the fourth portion **144** are connected and the third portion **143** may be parallel to each other.

In this case, the portion where the first portion **141** and the fourth portion **144** are connected may form a substantially flat plane.

When the second portion **142** of the light absorbing layer **140** positioned in the gap G between the display modules **100A** and **100B** is positioned only within the gap G, the second portion **142** of the light absorbing layer **140** may be essentially convex or concave in the process of forming the second portion **142.**

The light absorbing layer **140** may be formed by injecting a black resin material such as a photoresist having a black color, and the resin material may have an engraved or embossed shape during injection. Therefore, it is difficult to maintain flatness when the light absorbing layer **140** is formed.

Yet, when the first portion **141,** the second portion **142,** and the third portion **143,** which are continuously positioned by the fabricating method as in the embodiment of the present disclosure, are formed, the flatness of the light absorbing layer **140** formed in the gap G may be maintained.

In other words, according to the embodiment of the present disclosure, it may be able to secure the flatness of the portion of the light absorbing layer **140,** which is formed in the gap G and exposed to the outside of the gap G, i.e., the flatness of the first portion **141** and the third portion **143.**

Therefore, according to the embodiment of the present disclosure, by the light absorbing layer **140** of which flatness is maintained, the gap between the display modules **100A** to **100B** may be prevented from being distinguished or the continuity of the screen may be prevented from being degraded.

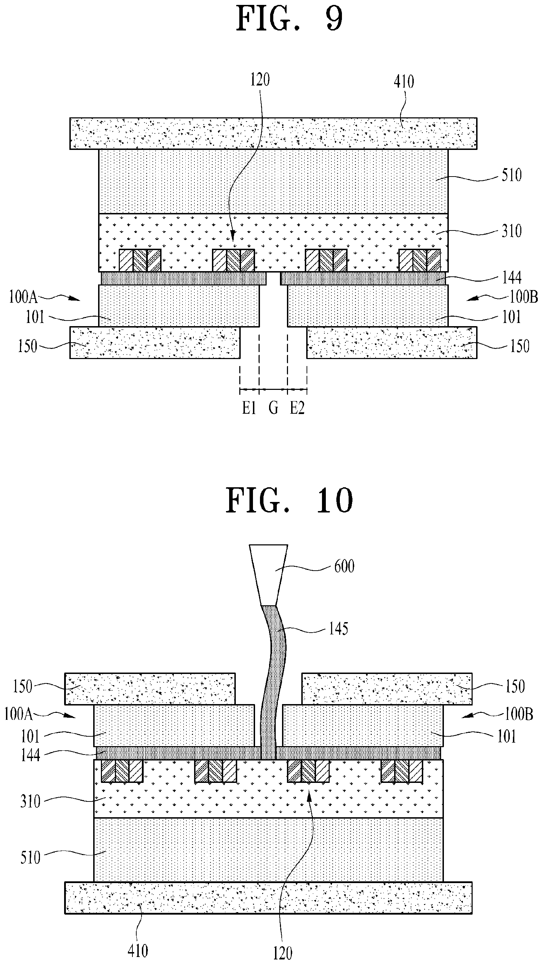

FIGs. 9 to 12 are cross-sectional diagrams schematically illustrating respective steps of a method of fabricating a display device according to another embodiment of the present disclosure.

Hereinafter, a method of fabricating a display device according to another embodiment of the present disclosure will be described with reference to FIGs. 9 to 12. Each step of FIGs. 9 to 12 will be described with reference to FIG. 4.

First, referring to FIG. 4 and FIG. 9, at least two display modules **100A** to **100B** may be prepared (S10). As described above, each of the display modules **100A** and **100B** may be in a state that semiconductor light emitting devices **120** forming a plurality of pixels are mounted on a substrate **101.** In addition, a fourth portion **144** of a light absorbing layer **140** may be formed on a first surface of the substrate **101.** The light absorbing layer **140** may include a black matrix.

The at least two display modules **100A** and **100B** may be disposed adjacent to each other in a manner of forming a predetermined gap G on a support layer 150 (S20). Here, as described above, the support layer **150** may be positioned such that an exposed portion E1/E2 exposing at least a portion of a second surface (i.e., a surface opposite to the surface on which the light emitting device **120** is mounted) of the substrate **101** from a side of the gap G is formed. That is, a first exposed portion E1 may be formed on the first module **100A,** and a second exposed portion E2 may be formed on the second module **100B.**

Thereafter, an encapsulation layer **310** may be formed on the first surface of the substrate **101** (S30). The encapsulation layer **310** may planarize the first surface of the substrate **101** on which the semiconductor light emitting device **120** is formed. In addition, the encapsulation layer **310** may planarize a light absorbing material when the light absorbing material is injected in a subsequent step.

The encapsulation layer **310** may include a release protection film. The release protection film may be a film temporarily positioned on the first surface of the substrate **101.**

The step S30 of forming the encapsulation layer may include a step of forming or attaching a release protection film on the at least two display modules **100A** to **100B,** on which the semiconductor light emitting devices **120** are mounted, onto the first surface of the substrate **101.**

The release protection film may include at least one of a UV release film, a thermal release film, and a low adhesion protection film, which can be easily removed in a subsequent process.

The release protection film may be attached to or directly formed on the first surface of the substrate **101** on which the semiconductor light emitting device **120** is formed. In doing so, the release protection film may be formed or attached in a manner of filling up the gap G or failing to infiltrate into the gap G.

A transparent cover **510** may be disposed on the encapsulation layer **310.** The transparent cover **510** may cover the entire display device including a plurality of modules.

Thereafter, an upper jig **410** may be positioned on the transparent cover **510.** The upper jig **410** may be temporarily attached to the transparent cover **510.**

As described above, after the steps S **10** to S**40** are performed, the state shown in FIG. 9 may be obtained.

Next, as shown in FIG. 10, the structure of the state, in which the support layer **150** is installed and the encapsulation layer **310** and the transparent cover **510** are located on the display modules **100A** and **100B,** may be reversed using the upper jig **410.**

That is, referring to FIG. 10, the upper jig **410** may be positioned on a top side and the support layer **150** may be positioned on a bottom side..

In this state, a sealing material **145** may be injected into the gap G (S50). As the sealing material **145,** a black resin material may be injected into the gap G. The black resin may be a material forming a black matrix. That is, the black resin may be the same material as that of the fourth portion **144** of the light absorbing layer **140.**

As described above, when the black resin is injected into the gap G formed between the adjacent display modules **100A** and **100B,** the black resin first fills a space between the fourth portions **144** of the light absorbing layer **140** positioned on the first surfaces of the substrates **101.**

In this case, since the encapsulation layer **310** is located at a space portion between the fourth portions **144** of the light absorbing layer **140,** the black resin may fill the space between the fourth portions **144** of the light absorbing layer **140** to form a flat surface. That is, the flatness of the injected black resin may be maintained by the encapsulation layer **310.** The black resin injected into the space between the fourth portions **144** of the light absorbing layer **140** may form a first portion **141** of the light absorbing layer **140** described above.

Subsequently, the black resin may continue to fill the space between the fourth portions **144** of the light absorbing layer **140** and then continuously fill up the gap G. As described above, the black resin filling up the gap G may form a second portion **142** of the light absorbing layer **140.**

Subsequently, the black resin may be formed on the second surface of the substrate **101** after filling up the gap G. In this case, the black resin formed on the second surface of the substrate **101** may form a third portion **143** of the light absorbing layer **140.** In this case, the third portion **143** of the light absorbing layer **140** may be located in the space between the support layers **150** described above, that is, on the exposed portion E1/E2. The flatness of the third portion **143** may be maintained on the second surface of the substrate **101.**

The black resin may then be cured to form the light absorbing layer **140.**

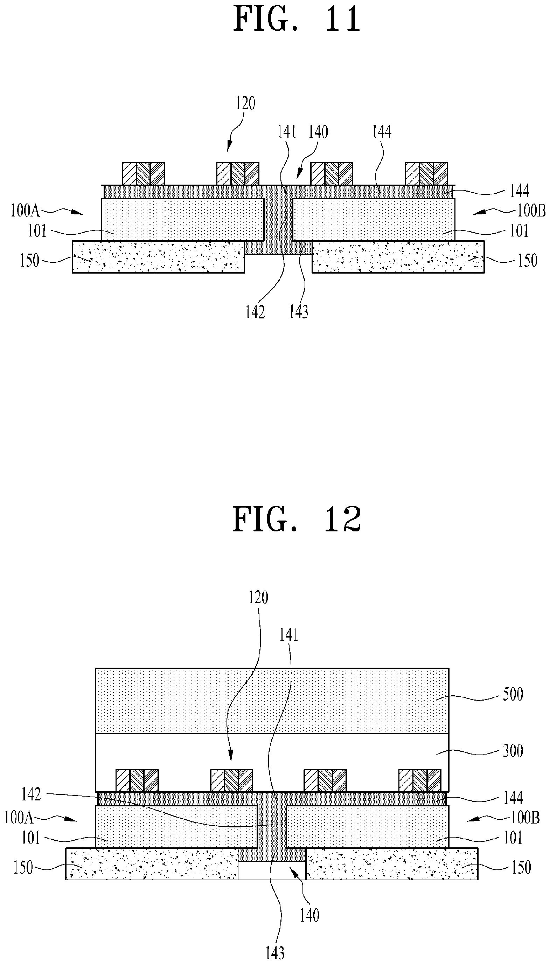

When the display modules **100A** and **100B** are reversed again to its original position using the upper jig **410** and the release protection film forming the encapsulation layer **310** and the transparent cover **510** are removed together, the state shown in FIG. 11 may be obtained.

As described above, the first portion **141,** the second portion **142,** and the third portion **143** of the light absorbing layer **140** may be continuously disposed, and the first portion **141** and the third portion **143** may be parallel to each other. More specifically, the portion where the first portion **141** and the fourth portion **144** are connected and the third portion **143** may be parallel to each other.

In this case, the portion where the first portion **141** and the fourth portion **144** are connected may form a substantially flat plane.

Next, as shown in FIG. 12, an encapsulation layer **300** may be formed on the first surface of the substrate **101.** The encapsulation layer **300** may planarize the first surface of the substrate **101** on which the semiconductor light emitting device **120** is formed.

The encapsulation layer **300** may include a high transmission layer such as an Optically Clear Adhesive (OCA) film or an Optically Clear Resin (OCR). The optically clear adhesive film may be formed in a manner of being attached onto the first surface of the substrate **101** on which the semiconductor light emitting device **120** is formed. Meanwhile, the optically clear resin may be directly formed on the first surface of the substrate **101** on which the semiconductor light emitting device **120** is formed. In this case, the high transmission layer may be formed or attached in a manner of filling up the gap G or failing to infiltrate into the gap G.

A transparent cover **500** may be disposed on the encapsulation layer 300. The transparent cover **500** may cover the entire display device including a plurality of the modules.

In some cases, the support layer **150** may be removed.

In addition, other redundant descriptions will be omitted.

As described above, when the first portion **141,** the second portion **142,** and the third portion **143** which are continuously positioned by the fabricating method according to the embodiment of the present disclosure are formed, the flatness of the light absorbing layer **140** formed in the gap G may be maintained.

In other words, according to the embodiment of the present disclosure, it may be able to secure the flatness of the portion of the light absorbing layer **140,** which is formed in the gap G and exposed to the outside of the gap G, i.e., the flatness of the first portion **141** and the third portion **143.**

Therefore, according to the embodiment of the present disclosure, by the light absorbing layer **140** of which flatness is maintained, the gap between the display modules **100A** to **100B** may be prevented from being distinguished or the continuity of the screen may be prevented from being degraded.

The above description is merely illustrative of the technical idea of the present disclosure. Those of ordinary skill in the art to which the present disclosure pertains will be able to make various modifications and variations without departing from the essential characteristics of the present disclosure.

Therefore, embodiments disclosed in the present disclosure are not intended to limit the technical idea of the present disclosure, but to describe, and the scope of the technical idea of the present disclosure is not limited by such embodiments.

The scope of protection of the present disclosure should be interpreted by the claims below, and all technical ideas within the scope equivalent thereto should be construed as being included in the scope of the present disclosure.

### INDUSTRIAL APPLICABILITY

The present disclosure may provide a modular display device using a light emitting device, a modular display device using the same, and a fabricating method thereof.

## Claims

1. A modular display device, comprising:
at least two display modules, each including a substrate having a first surface and a second surface and a plurality of semiconductor light emitting devices mounted on the first surface of the substrate;
a light absorbing layer disposed in a gap between the display modules; and
an encapsulation layer disposed on first surfaces of the display modules,
wherein the light absorbing layer comprises a first portion disposed on the first surface of the substrate, a second portion disposed in the gap between the display modules adjacent to each other, and a third portion disposed on the second surface of the substrate.

2. The modular display device of claim 1, further comprising a support layer disposed on at least a portion of the second surface of the substrate.

3. The modular display device of claim 1, wherein the third portion is disposed between the support layers disposed on the adjacent modules.

4. The modular display device of claim 1, wherein the support layer is disposed such that an exposed portion exposing at least a portion of the second surface from a side of the gap is formed.

5. The modular display device of claim 4, wherein the third portion is disposed on the exposed portion.

6. The modular display device of claim 1, wherein the first portion, the second portion, and the third portion are continuously disposed.

7. The modular display device of claim 1, wherein the first portion and the third portion are parallel to each other.

8. The modular display device of claim 1, wherein the first portion and the third portion substantially form a plane.

9. The modular display device of claim 1, wherein the substrate comprises a wiring electrode electrically connected to a contact electrode of the semiconductor light emitting device.

10. The modular display device of claim 9, wherein the substrate comprises a glass substrate and a TFT layer formed on the glass substrate and connected to the wiring electrode.

11. The modular display device of claim 1, wherein the second portion is configured to improve an adhesive force of the adjacent modules.

12. The modular display device of claim 1, wherein a transparent cover is disposed on the encapsulation layer.

13. A method of fabricating a modular display device, the method comprising:
preparing at least two display modules, each having semiconductor light emitting devices mounted on a first surface of a substrate;
disposing the display modules adjacent to each other on a support layer to leave a gap in between such that the support layer is disposed on a second surface of the substrate;
disposing an encapsulation layer on the first surface of the substrate;
disposing an upper jig on the substrate positioned on the support layer; and
injecting a light absorbing material into the gap after reversing the display modules together with the supporting layer,
wherein the light absorbing material is injected from a side of the second surface of the substrate to come in contact with the first surface of the substrate.

14. The method of claim 13, wherein injecting the light absorbing material is performed until the light absorbing material is disposed on the second surface.

15. The method of claim 13, wherein the support layer is disposed in a manner of being separated from each other so that the adjacent portion is opened.

16. The method of claim 13, wherein the support layer is disposed such that an exposed portion exposing at least a portion of the second surface from a side of the gap is formed.

17. The method of claim 16, wherein injecting the light absorbing material comprises injecting the light absorbing material onto the exposed portion.

18. The method of claim 13, wherein the encapsulating layer planarizes the light absorbing material when the light absorbing material is injected into the exposed portion.

19. The method of claim 13, wherein disposing the encapsulation layer comprises forming or attaching a release protection film on the at least two display modules, each having the semiconductor light emitting devices mounted on the first surface of the substrate.

20. The method of claim 13, wherein injecting the light absorbing material comprises injecting the light absorbing material until the light absorbing material comes in contact with the second surface after coming in contact with the first surface and then filling up the gap.
